# EUROPEAN PATENT SPECIFICATION

(11) **EP 2 951 860 B1**
(45) Date of publication and mention of the grant of the patent: **11.03.2020**
(21) Application number: 13705929.1
(22) Date of filing: 31.01.2013
(51) Int. Cl.: H01L 21/683, H01L 21/67, H01L 21/673, H01L 21/687

(54) **CARRIER SUBSTRATE AND METHOD FOR FIXING A SUBSTRATE STRUCTURE**
TRÄGERSUBSTRAT UND VERFAHREN ZUR BEFESTIGUNG EINER SUBSTRATSTRUKTUR
SUBSTRAT PORTEUR ET PROCÉDÉ DE FIXATION D'UNE STRUCTURE DE SUBSTRAT

(43) Date of publication of application: 09.12.2015
(73) Proprietor: Fraunhofer-Gesellschaft zur Förderung der angewandten Forschung e.V., 80686 München (DE)
(72) Inventor: LANDESBERGER, Christof, 82166 Gräfelfing (DE)
(74) Representative: Hersina, Günter
(86) International application number: PCT/EP2013/051977
(87) International publication number: WO 2014/117853

(56) References cited:
- US-A1- 2005 266 174
- US-A1- 2008 064 184
- US-A1- 2009 200 251

## Description

### Technical Field

The present invention generally relates to a carrier substrate for supporting a substrate structure having a process substrate and a frame structure and a method for fixing a substrate structure having a process substrate and a frame structure to a carrier substrate. In particular, the present invention relates to a carrier substrate with an edge depression, a method for reversibly fixing a semiconductor substrate and a method for processing a substrate. Further embodiments of the present invention relate to a complementary carrier wafer.

### Background of the Invention

In the prior art, the production of wafers with a reinforced wafer edge is known. There are conventional machines for the production of such wafers. The production of such wafers is, for example, based on a particular grinding process. Furthermore, electrostatic carrier technology and mobile electrostatic carriers are known in the prior art.

For instance, document US 2008/0064184 discloses an apparatus configured for holding a substrate to be processed, said substrate comprising a peripheral non-thinned wafer edge.

Furthermore, there are known technologies for singularizing a thin wafer into individual chips by means of plasma methods. Furthermore, reversible carrier technologies with adhesives and thermoplastics are known in the prior art.

However, known carrier solutions are disadvantageous in that they are not optimized for a reliable support of such wafers having a reinforced wafer edge.

Therefore, it is an object of the present invention to provide an improved concept for supporting a substrate structure having a process substrate and a frame structure which allows for a more reliable support of the substrate structure.

This object is achieved by a carrier substrate according to claim 1 and a method according to claim 13.

According to an embodiment of the present invention, a carrier substrate for supporting a substrate structure having a process substrate and a frame structure comprises a base portion and a support portion. The support portion is arranged on the base portion, wherein the support portion and the base portion form a recess region for receiving the frame structure of the substrate structure. The support portion comprises a support surface area for supporting the process substrate of the substrate structure.

The present invention is based on the finding that the above-mentioned more reliable support of the substrate structure can be realized if a recess region for receiving the frame structure of the substrate structure is formed and if the substrate structure is arranged onto the carrier substrate such that the frame structure of the substrate structure is received by the recess region. In this way, the substrate structure having the process substrate and the frame structure can reliably be fixed to the carrier substrate.

According to a further embodiment, the carrier substrate comprises a fixing device for electrostatically or mechanically fixing the substrate structure to the carrier substrate. By providing the fixing device, it is possible to further improve the support of the substrate structure.

According to a further embodiment, the carrier substrate comprises a via extending through the base portion and the support portion. Here, the via extends from a bottom surface area of the base portion to the support surface area of the support portion. Furthermore, the bottom surface area of the base portion is opposite to the support surface area of the support portion. By providing the via extending through the base portion and the support portion, it is possible to induce a negative pressure for further increasing the support of the substrate structure.

A further embodiment of the present invention provides a method for fixing a substrate structure having a process substrate and a frame structure to a carrier substrate. The method comprises providing a carrier substrate, the carrier substrate comprising a base portion and a support portion arranged thereon, wherein the support portion and the base portion form a recess region for receiving the frame structure of the substrate structure, wherein the support portion comprises a support surface area for supporting the process substrate of the substrate structure, and arranging the substrate structure onto the carrier substrate such that the frame structure of the substrate structure is received by the recess region.

According to a further embodiment, the method further comprises applying an adhesive onto a top surface area of the base portion. Here, the top surface area of the base portion is adjacent to a side surface area of the support portion. Furthermore, the side surface area of the support portion is adjacent to the support surface area.

In the following, embodiments of the present invention will be explained with reference to the accompanying drawings, in which:
- Fig. 1: shows a schematic cross-sectional view of an embodiment of a carrier substrate for supporting a substrate structure having a process substrate and a frame structure;
- Figs. 2a to 2c: show schematic cross-sectional views of different embodiments of carrier substrates for supporting a substrate structure having a process substrate and a frame structure;
- Fig. 3: shows a schematic cross-sectional view of an embodiment of a carrier substrate for supporting a substrate structure having a membrane substrate and a frame structure;
- Figs. 4a and 4b: show schematic cross-sectional views of an embodiment of a carrier substrate for supporting a substrate structure having a process substrate and a frame structure with a fixing device and/or a via; and
- Fig. 5: shows a schematic cross-sectional view of an embodiment of a carrier substrate for supporting a substrate structure having a process substrate and a frame structure with an adhesive applied to the carrier substrate.

Before discussing the present invention in further detail using the drawings, it is pointed out that in the figures, identical elements, elements having the same function or the same effect are provided with the same reference numerals, so that the description of these elements and the functionality thereof illustrated in the different embodiments is mutually exchangeable or may be applied to one another in the different embodiments.

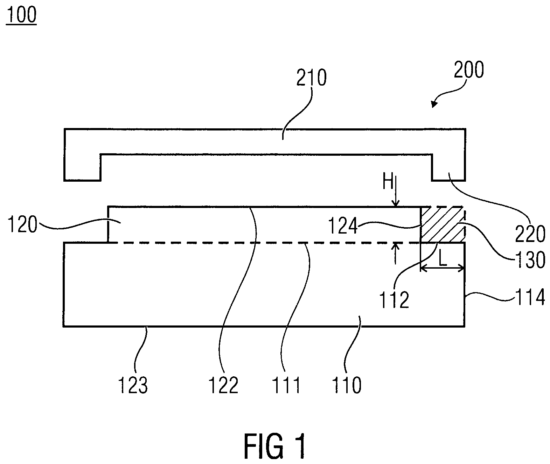

Fig. 1 shows a schematic cross-sectional view of an embodiment of a carrier substrate 100 for supporting a substrate structure 200 having a process substrate 210 and a frame structure 220. As shown in Fig. 1, the carrier substrate 100 comprises a base portion 110 and a support portion 120 arranged thereon, wherein the support portion 120 and the base portion 110 form a recess region 130 for receiving the frame structure 220 of the substrate structure 200. The support portion 120 comprises a support surface area 122 for supporting the process substrate 210 of the substrate structure 200.

By providing the embodiment of the carrier substrate 100 shown in Fig. 1, it is possible to more reliably support the substrate structure. This can essentially be achieved by providing complementary elements in the form of the carrier substrate and the substrate structure. The provision of the complementary elements has the advantage that it guarantees a more stable handling and that a slipping of the supported substrate structure can be prevented. This is especially important for practical applications. For example, in a horizontal or only slightly inclined position, a secure handling of the carrier substrate is possible.

In embodiments, the support portion 120 may be formed integrally with the base portion 110. In other words, the support portion 120 and the base portion 110 may be formed as one-piece.

According to embodiments, the support portion 120 and the base portion 110 may be separate pieces or elements. In case the support portion 120 and the base portion 110 are separate pieces, the support portion 120 and the base portion 110 may comprise a common surface area as indicated by the dashed line 111.

In the embodiment of Fig. 1, the recess region 130 is arranged laterally adjacent to the support surface area 122. The laterally adjacent recess region 130 is exemplarily depicted in Fig. 1 as a shaded region.

Referring to the embodiment of Fig. 1, the recess region 130 may be defined in the following way. The support portion 120 may comprise the support surface area 122 and a side surface area 124. As shown in Fig. 1, the side surface area 124 may be adjacent to the support surface area 122. Furthermore, the base portion 110 may comprise a top surface area 112 and a side surface area 114. As shown in Fig. 1, the top surface area 112 of the base portion 110 may be adjacent to the side surface area 124 of the support portion 120. In addition, the side surface area 114 of the base portion 110 may be adjacent to the top surface area 112 of the base portion 110. The recess region 130 is bordered by the side surface area 124 of the support portion 120 and the top surface area 112 of the base portion 110.

In the embodiment of Fig. 1, the side surface area 124 of the support portion 120 is laterally offset with respect to the side surface area 114 of the base portion 110, while the top surface area 112 of the base portion 110 is vertically offset with respect to the support surface area 122 of the support portion 120.

In embodiments, the support portion 120 and the base portion 110 form a step like recess region 130.

In addition, the recess region 130 may comprise any other geometrical shape (e.g. in the form of a groove or depression).

According to embodiments, a lateral (or horizontal) direction or extension is defined to be parallel to the support surface area 122, while a vertical direction or extension is defined to be perpendicular to the support surface area 122.

Referring to the embodiment of Fig. 1, the recess region 130 has a lateral extension L and a vertical extension H. For example, the recess region 130 has a lateral extension L ranging from 0.1 mm to 20 mm or from 0.2 mm to 10 mm, wherein the lateral extension L is parallel to the support surface area 122. Furthermore, the recess region 130 may have a vertical extension H ranging from 50 µm to 1 mm or from 100 µm to 500 µm, wherein the vertical extension H is parallel to a side surface area 124 of the support portion 120, wherein the side surface area 124 of the support portion 120 is adjacent to the support surface area 122.

The inventive carrier substrate may be implemented and realized with different dimensions, wherein the respective configuration of the carrier substrate and the chosen dimensions can, for example, be based on the respective specific application case and can, for example, considerably deviate from the following exemplarily specified dimensions.

In a typical wafer processing, the dimensions (lateral and vertical extensions) of the carrier substrate 100 correspond to standard dimensions/sizes of a semiconductor standard wafer. In this way, it is possible to use conventional wafer cassettes (carriers) for handling the wafer stack (i.e. carrier substrate and substrate structure supported by the carrier substrate) in a process facility.

For example, the lateral extension of the carrier substrate 100 may be 100 mm (4-inch), 150 mm (6-inch), 200 mm (8-inch) or 300 mm (12-inch). Furthermore, the vertical extension (between a bottom surface area 123 of the carrier substrate 100 and the support surface area 122) of the carrier substrate 100 may range from 400 µm to 800 µm. According to embodiments, the carrier substrate 100 can be dimensioned so that the thickness of the resulting wafer stack (i.e. the carrier substrate 100 and the substrate structure 200 supported by the carrier substrate 100) does not exceed the thickness of a standard wafer having a standard dimension/size.

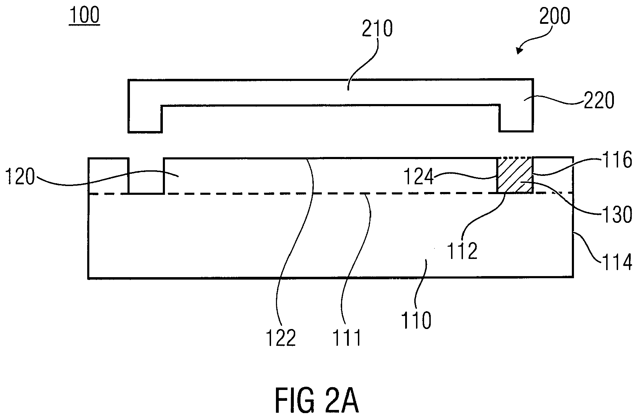

Figs. 2a to 2c show schematic cross-sectional views of different embodiments of carrier substrates 100 for supporting a substrate structure 200 having a process substrate 210 and a frame structure 220. The different embodiments of the carrier substrates 100 according to Figs. 2a to 2c essentially correspond to the embodiment of the carrier substrate 100 according to Fig. 1. In the embodiment of Fig. 2a, the recess region 130 is indicated by a shaded region. For example, the recess region 130 is bordered by the side surface area 124 of the support portion 120, the top surface area 112 of the base portion 110 and a further side surface area 116 of the support portion 120. The further side surface area 116 of the support portion 120 may be adjacent to the top surface area 112 of the base portion. Furthermore, the further side surface area 116 of the support portion 120 may be parallel to the side surface area 124 of the support portion 120 and the side surface area 114 of the base portion 110. According to the embodiment of Fig. 2a, the recess region 130 may be defined by two parallel side surface areas 124, 116 of the carrier substrate 110. Furthermore, the recess region 130 may be configured for receiving the frame structure 220 of the support structure 200, wherein the frame structure 220 and the recess region 130 have approximately the same lateral extension. By providing the carrier substrate 100 according to the embodiment of Fig. 2a, the support of the substrate structure 200 can be further improved. This is due to the fact that the substrate structure 200 is supported from two opposite sides (e.g. the side surface areas 124, 116 of the carrier substrate) such that a lateral shift or slip will be prevented.

According to the embodiment of Fig. 2a, the part of the support portion 120 which is laterally adjacent to the recess region 130 (or to the further side surface area 116 of the support portion 116) may be configured as shown in Fig. 2a, or may have any different shape.

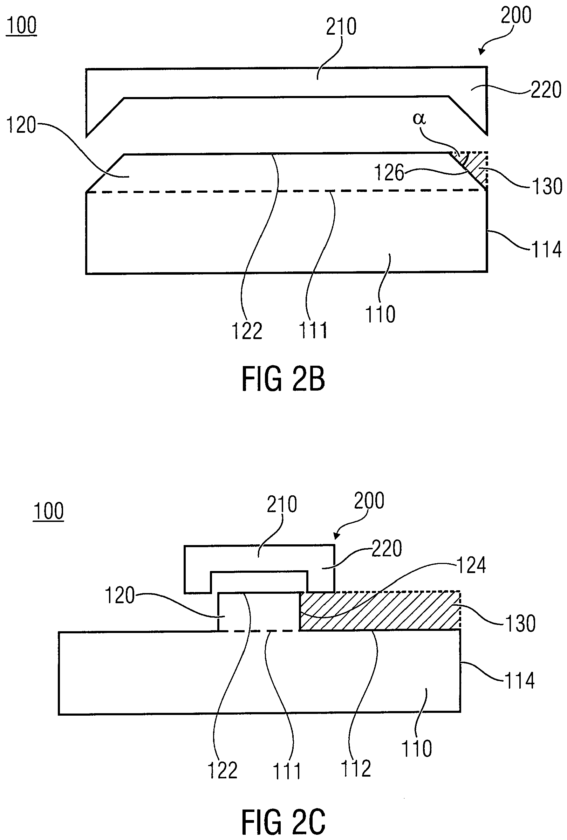

In the embodiment of Fig. 2b, the recess region 130 is formed like a triangular shape. For example, the recess region 130 is defined by a tilted side surface area 126 of the support portion 120. Here, the tilted side surface area 126 of the support portion 120 may be adjacent to the side surface area 114 of the base portion 110 and adjacent to the support surface area 122 of the support portion 120. Furthermore, the tilted side surface area 126 of the support portion 120 may be tilted with respect to the side surface area 114 of the base portion 110 and tilted with respect to the support surface area 122 of the support portion 120. According to the embodiment of Fig. 2b, the frame structure 220 of the substrate structure 200 may be complementary to the triangular shaped recess region 130 of the carrier substrate 100. This allows to reliably support the substrate structure 200 by the carrier substrate 100.

Referring to the embodiment of Fig. 2b, the tilting angle α between a lateral extension adjacent to the support surface area 122 and the tilted side surface area 126 of the support portion 120 may range from above 0° to 90°.

In the embodiment of Fig. 2c, the recess region 130 is indicated by a shaded region. The lateral extension of the recess region 130 in the embodiment of Fig. 2c is larger than compared to the lateral extension of the recess region 130 in the embodiments of Figs. 2a and 2b. For example, the lateral extension of the recess region 130 in Fig. 2c is larger than one quarter, one third or half of the lateral extension of the base portion 110. The carrier substrate 100 of Fig. 2c may be configured to support a comparatively small substrate structure 200. By providing the carrier substrate 100 according to the embodiment of Fig. 2c, it is possible to fix comparatively small substrate structures (or wafers having a relatively small lateral extension when compared to the lateral extension of the base portion 110 of the carrier substrate 100). The comparatively small substrate structures may have different sizes. The carrier substrate 100 of Fig. 2c essentially allows to reliably fix such wafers onto the carrier substrate. In other words, the recess region 130 or the border region of the carrier substrate is relatively wide (i.e. has a relatively large lateral extension). For example, the carrier substrate 100 according to Fig. 2c can be used to support or fix 4" or 6" wafers onto an 8" carrier substrate. This essentially allows to process the wafers in a process facility without requiring to change or modify existing handling systems or conventional carrier substrates (wafer chucks).

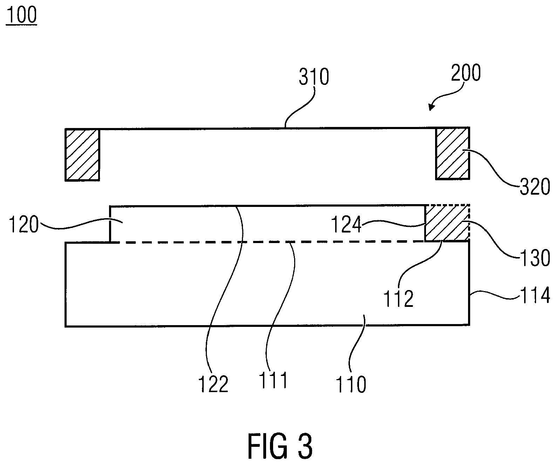

Fig. 3 shows a schematic cross-sectional view of an embodiment of a carrier substrate 100 for supporting a substrate structure 200 having a membrane substrate 310 and a frame structure 320. The membrane substrate 310 and the frame structure 320 of the substrate structure 200 shown in Fig. 3 may correspond to the process substrate 210 and the frame structure 220 of the substrate structure 200 shown in Fig. 1. For example, the membrane substrate 310 of Fig. 3 is a plan-parallel wafer (i.e. without an edge reinforcement). Furthermore, the frame structure 320 shown in Fig. 3 may be a ring frame structure. The ring frame structure may be arranged at the edges of the membrane substrate 310, as shown in Fig. 3. In the embodiment of Fig. 3, the recess region 130 may be configured for receiving the ring frame structure 320, while the support surface area 122 of the support portion 120 may be configured for supporting the membrane substrate 310 of the substrate structure 200.

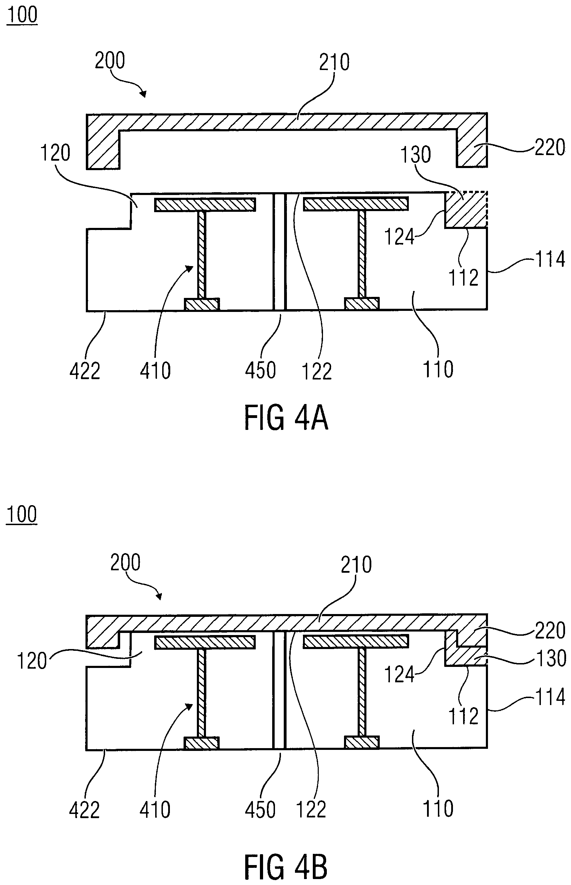

Figs. 4a and 4b show schematic cross-sectional view of an embodiments of a carrier substrate 100 for supporting a substrate structure 200 having a process substrate 210 and a frame structure 220 with a fixing device 410 and/or a via 450. In the embodiments of Figs. 4a and 4b, the recess region 130 is indicated by a shaded region. The embodiment of Fig. 4a illustrates the case where the substrate structure 200 is not yet supported by the carrier substrate 100, while the embodiment of Fig. 4b illustrates the case where the substrate structure 200 is supported by the carrier substrate 100. In the case of Fig. 4b, the process substrate 210 of the substrate structure 200 may be adjacent to the support surface area 122 of the support portion 120. Furthermore, there may be a relatively small cavity or hollow space between the process substrate 210 and the support surface area 122 of the support portion 120. In embodiments, the substrate structure 200 may be adjacent to the carrier substrate 100 within a tolerance range. According to embodiments, the recess region 130 is configured to be complementary to the frame structure 220 of the substrate structure 200 such that the frame structure 220 will be adjacent to the side surface area 124 of the support portion 120 and/or the top surface area 112 of the base portion 110 within a tolerance range (see, e.g. Fig. 4b).

In embodiments, the carrier substrate 100 may comprise a fixing device 410 for electrostatically fixing the substrate structure 200 to the carrier substrate 100.

According to embodiments, the carrier substrate 100 may comprise a fixing device 410 for mechanically fixing the substrate structure 200 to the carrier substrate 100.

By providing the fixing device 410 for electrostatically and/or mechanically fixing the substrate structure 200 to the carrier substrate 100, it is possible to further increase the reliability of the fixing or the support.

Here, it is pointed out that the effect of the form of the carrier substrate and the electrostatic/mechanical fixing provided by the fixing device can aid each other in order to ensure a more reliable fixing of the substrate structure to the carrier substrate.

According to embodiments, the fixing device 410 may comprise an electrode structure arranged on the carrier substrate 100. For example, the electrode structure is configured to electrostatically fix the substrate structure 200 using a unipolar configuration or a bipolar configuration.

In embodiments, the fixing device 410 may comprise a first conductive region and a second conductive region. For example, the first conductive region and the second conductive region are separately arranged on the carrier substrate 100. Furthermore, the first conductive region and the second conductive region may be configured to electrically contact the process substrate 210 (or to fix the substrate structure 200 using an electrical polarization).

According to embodiments, the carrier substrate 100 may comprise a via 450 extending through the base portion 110 and the support portion 120. For example, the via 450 extends from a bottom surface area 422 of the base portion 110 to the support surface area 122 of the support portion 120. Here, the bottom surface area 422 of the base portion 110 is opposite to the support surface area 122 of the support portion 120.

The provision of the via 450 extending through the base portion 110 and the support portion 120 of the carrier substrate 110 allows to generate a negative pressure for further increasing the support or fixing of the substrate structure 200. For example, a vacuum plate can be attached to the carrier substrate 100 configured to induce the negative pressure, thereby pulling the substrate structure 200 against the support surface area 122 of the support portion 120.

In embodiments, the carrier substrate 100 may comprise a circular recess region 130 for receiving a circular frame structure 220 of the substrate structure 200.

For example, in a top view, the recess region 130 is a circular or circumferential recess region arranged along the edge of an example circularly shaped base portion 110. Furthermore, the circular frame structure 220 may be adapted to fit into this circular recess region 130.

In a top view, the base portion 110 and the support portion 120 may have a circular shape, a rectangular shape or any other polygonal shape. Furthermore, the support portion 120 and the base portion 110 may form a circumferential recess region 130 having, in a top view, a circular shape, a rectangular shape or any other polygonal shape.

In embodiments, the substrate structure 200 and the carrier substrate 100 comprise the same coefficient of thermal expansion. For example, the substrate structure 200 and the carrier substrate 100 comprise silicon.

By providing the substrate structure 200 and the carrier substrate 100 with the same coefficient of thermal expansion, it is possible to keep the state of the support or fixing of the substrate structure 200 when handling the carrier substrate 100 or processing the substrate structure 200 (e.g. using a high temperature condition).

In embodiments, the carrier substrate 100 may comprise silicon for thermally conducting heat away from the carrier substrate 100.

According to embodiments, the recess region 130 may have a shape, wherein the side surface area 124 of the support portion 120 and the top surface area 112 of the base portion 110 are not straight but rounded, or have any other characteristics. For example, the recess region 130 may have a concave shape.

Further embodiments of the present invention relate to a method for fixing a substrate structure 200 having a process substrate 210 and a frame structure 220 to a carrier substrate 100. The method comprises providing a carrier substrate 100 according to the embodiment of Fig. 1 and arranging the substrate structure 200 onto the carrier substrate 100 such that the frame structure 220 of the substrate structure 200 is received by the recess region 130.

In embodiments, the method further comprises electrostatically and/or mechanically fixing the substrate structure 200 to the carrier substrate 100.

By the step of electrostatically and/or mechanically fixing the substrate structure 200 to the carrier substrate 100, the supporting action (or supporting force) can be further increased.

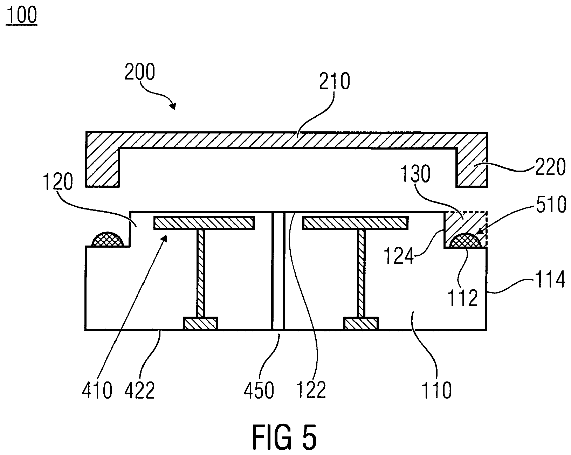

Fig. 5 shows a schematic cross-sectional view of an embodiment of a carrier substrate 100 for supporting a substrate structure 200 having a process substrate 210 and a frame structure 220 with an adhesive 510 applied to the carrier substrate 100. The carrier substrate 100 shown in Fig. 5 essentially corresponds to the carrier substrates 100 shown in Figs. 4a and 4b. In the embodiment of Fig. 5, the recess region 130 is indicated by a shaded region. Furthermore, the carrier substrate 100 may comprise the fixing device 410 and/or the via 450.

The embodiment of the carrier substrate 100 of Fig. 5 may be obtained from the step of providing the carrier substrate included by the method for fixing the substrate structure 200.

For example, the method further comprises applying an adhesive 510 onto a top surface area 112 of the base portion 110. Here, the top surface area 112 of the base portion 110 is adjacent to a side surface area 124 of the support portion 120. Furthermore, the side surface area 124 of the support portion 120 is adjacent to the support surface area 122. By applying the adhesive 510 onto the top surface area 112 of the base portion 110, the frame structure 220 of the substrate structure 200 can be firmly stuck together with the base portion 110 of the carrier substrate 100. This makes the support of the substrate structure 200 even more reliable. Furthermore, the application of the adhesive 510 onto the top surface area 112 of the base portion 110 is advantageous in that the substrate structure 200 and the carrier substrate 100 can securely be sealed such that, for example, an etching medium cannot penetrate into a cavity or hollow space formed between the process substrate 210 of the substrate structure 200 and the support surface area 122 of the support portion 120.

In embodiments, the adhesive 510 may be applied as a continuous line along a circular or circumferential recess region 130 of the carrier substrate 100. In addition, the adhesive 510 may be applied non-continuously (e.g. in the form of separate points or separate regions) within the recess region 130 of the carrier substrate 100.

In summary, embodiments of the present invention provide a carrier substrate which is characterized in that the same allows a mechanical fixing of a deposited thin wafer (substrate structure 200).

The reliable fixing can be provided due to its specific design, wherein the mechanical fixing can additionally be combined with an electrostatic or an adhesive fixing method. The combinability of the holding or supporting principles allows a particularly high security in wafer production and the usage of the carrier substrate in several successive process steps.

In embodiments, the carrier substrate 100 is a wafer-shaped substrate of silicon, glass, sapphire (monocrystalline aluminum dioxide Al₂O₃) or a composite. A characteristic feature of the carrier wafer or substrate is a depression of the substrate edge (recess region 130) having a width or lateral extension of approximately 0.2 mm to 10 mm and a step height or vertical extension of approximately 100 µm to 500 µm, for example.

Here, it is noted that sapphire has a similar coefficient of thermal expansion as gallium arsenide (GaAs) and is typically used as a carrier for thin GaAs wafers. For simple processes/applications, the carrier substrate 100 can, for example, also be made of a plastic material.

The edge depression (recess region 130) allows a deposition or arrangement of a wafer substrate (substrate structure 200) having itself a reinforced wafer edge (frame structure 220). In this way, the thin wafer 200 to be stabilized and the carrier substrate 100 may fit in an approximately form-locking manner (see, e.g. Fig. 1).

Embodiments of the present invention provide the advantage that the superimposed pair of two substrates guarantees a stable handling and prevents slipping of the deposited wafer arranged on the carrier substrate. Thus, in an example horizontal or only slightly inclined position, a secure handling will be possible.

Embodiments provide a combination of the carrier substrate 100 with an adhesive connection (adhesive 510). The handling options can be significantly extended when the carrier substrate 100 is provided with a means for reversibly fixing the deposited wafer. This can, for example, be an adhesive 510 that is deposited on the top area (top surface area 112 of the base portion 110) of the edge depression in the form of points or as a continuous line (see, e.g. Fig. 5).

If a thin wafer with an edge reinforcement (substrate structure 200 with the frame structure 220) is arranged on the carrier substrate 100, the same may rest on the one hand flat and in direct contact with the carrier surface, and on the other hand the same can additionally be fixed by the adhesive 510 in the form of points or as a continuous adhesive line. If a continuous adhesive line is applied and the thin wafer 200 is arranged on the carrier substrate 100 in a vacuum environment, the vacuum is actually enclosed between the wafer 200 and the carrier 100 during edge adhesion. This means the areas are in close contact, i.e. with good thermal connection to the carrier 100. This is an important advantage in processes requiring high temperatures above 200°C, for example.

In embodiments, the following variations are possible for the choice of the adhesive 510. The adhesive 510 may comprise permanent glues (e.g. epoxy, acryl, ...), thermally detachable glues (e.g. wax, thermoplastics, ...,), chemically detachable polymers or also polymers that disintegrate under the effect of plasma (e.g. oxygen, fluorine, ...). Thus, a delaminating of the deposited wafer is possible when a thermoplastic is melted, solvents or etch media dissolve the adhesive joint, a laser beam separates the adhesive joint from the side, or the adhesion is separated by applying a mechanical force. Thermal disintegration of the adhesive 510 can also effect the detachment of the wafer 200 and carrier 100.

The specific advantages of the inventive carrier substrate with an edge depression are, in the case of a reversible adhesion technology, as follows.

The adhesive is not at the front of the wafer and hence does not interfere with the processing. A very small amount of adhesive is sufficient. The bottom of the wafer carrying the active structures or circuits does not contact the adhesive. Even after separating the adhesive joints, the thin wafer remains mechanically fixed due to the specific design of the carrier and can be moved and handled horizontally. When reaching the melting temperature in thermoplastic materials, the deposited wafer can be turned and lifted by applying a tangential force in a rotating movement. Due to the edge reinforcement, the thin wafer remains stable and can be securely handled even after a detachment. The wafer stack can also be used in a liquid or wet-chemical environment, wherein the continuous adhesive joint on the edge depression may seal the edge. After dissolving the adhesive joint and detaching the carrier, the carrier can be easily cleaned and can be reused multiple times. This is possible since only small amounts of adhesive are needed, and the adhesive joint is not in contact with a support surface of the carrier or with a central area of the bottom of the deposited wafer.

Embodiments provide a combination of the carrier with an electrostatic holding device (fixing device 410). An embodiment of the fixing device is an electrostatic holding device. In this case, polymer adhesives can be completely omitted. Instead, the deposited substrate can reversibly be fixed by electrostatic holding forces. Additionally, the electrostatic holding device can be implemented such that the holding force remains after a first activation (i.e. electrostatic charging) for a long time and also for high environmental temperatures without necessitating a continuous connection (i.e. electric cable) to an electric charge station. Thus, a mobile electrostatic carrier is formed that can be used in multiple ways. A specific characteristic of this electrostatic carrier is the edge depression or recess region allowing a "latching" of a deposited wafer with an edge reinforcement. Thus, a sliding or shifting of the deposited wafer is not possible, even when the electrostatic holding force, for example, due to leaking currents at high environmental temperatures will no longer be sufficient to securely fix the deposited wafer. Thus, the mechanical fixing of the wafer edge remains. In other words, the fixing of the substrate structure to the carrier substrate can be provided even if the electrostatic fixing provided by the fixing device becomes weaker or diminishes.

For the electrostatic holding device, two variations are possible. For example, a unipolar fixing and a bipolar fixing can be provided.

In a unipolar fixing, the deposited wafer and the carrier wafer form a plate capacitor arrangement, where the two substrates are provided with an opposite-pole electrostatic charge. This takes place, for example, by contacting the thin wafer or one of its surfaces with a negative voltage and the bottom carrier substrate or one of its surfaces with a positive voltage. An electrical insulating layer preferably lies between the two substrates or between the two charged surfaces. This can be an insulation on the carrier or an insulation on the wafer to be held or also a movable insulating layer, for example an electrically insulating foil (e.g. of polymer, ceramics, glass, ...). The purpose of the insulation is to avoid an electric short-circuit between the charged surfaces or the charged substrates.

In a bipolar electrostatic fixing, an electrode structure can be deposited on the carrier substrate comprising two or more separate conductive areas which are electrically insulated both with respect to each other and with respect to the carrier substrate and the deposited substrate. The conductive areas can consist of a metal layer or a conductive semiconductor layer (e.g. polysilicon, doped silicon), carbon or conductive ceramics (e.g. SiC). For the electric insulation layers, advantageously layers of silicon dioxide (glass), silicon nitride, aluminum oxide or ceramics can be used. The electrically conductive areas can be large electrodes or inter-digitated line-shaped areas (inter-digital electrodes, finger electrodes) or also a matrix arrangement of many electrostatically chargeable areas and structures. The conductive areas can be connected to contact pads that lie on a surface of the carrier substrate and that can be, at least temporarily, connected to an electrical charge station for the purpose of activating the electrostatic holding force. In an embodiment, the contact pads are at the back of the carrier substrate or at its lateral outer edge.

In some applications, it is advantageous to implement the bipolar electrode structure in a very fine manner, for example in a pattern of parallel lines having a width of 10 µm to 1 mm and a narrow spacing between the same of also 10 µm to 1 mm. This is, for example, required when not only large substrates are to be deposited and fixed, but also small objects, such as individual chip elements that might have a side length of only 100 µm to approximately 20 mm. The choice of the electrode geometry may be selected such that at least two opposite-pole chargeable electrode areas will lie below the area of an object to be held.

Further advantageous characteristics of the carrier with the edge depression are the implementation of small holes perpendicular through the carrier substrate. These holes can serve to effect negative pressure between the substrate to be held and the carrier substrate when the carrier itself is in connection with a negative pressure device, e.g. a vacuum plate. This is particularly advantageous since a possibly existing air cushion between the substrates can be exhausted and thus the deposited wafer will be in tight contact with the surface of the carrier substrate. This again significantly supports a successive electrostatic fixing.

A further usage of the vertical small holes (e.g. via 450 in Figs. 4a, 4b) through the carrier substrate results from the option of using the holes for passing gas, in particular helium. Helium is used as a cooling gas in different plasma equipment of semiconductor technology. In the case of using the helium gas stream with the inventive carrier, the helium effects a very good thermal coupling between the carrier and the deposited wafer. This is particularly advantageous in exothermic etching processes, for example silicon dry etching with fluorine-containing etching gas.

Embodiments provide a combination of the carrier with the edge depression with the electrostatic and the gluing holding device. The electrostatic fixing and adhesive etch sealing allow further variations for processing a deposited thin wafer. For example, the electrostatic fixing can almost be added when a close contact of the wafer and the carrier is desired, for example in process environments with a high temperature.

A further advantage of the combination with the electrostatic fixing results from a process example for singulating a wafer into chips by means of plasma etching as discussed below.

Further embodiments of the present invention provide a method for singulating a thin wafer into individual devices (e.g. chips, IC devices) by means of a plasma method applying the inventive carrier substrate. For example, a circuit wafer or otherwise structured silicon wafer is prepared such that the same is thinned from the back to a residual thickness of below 200 µm, preferably 10 µm to 100 µm. Thinning is performed such that a small edge area of the wafer remains. A large thin silicon membrane results which is held and stabilized at the edge by a thicker circular ring.

For this process step, a known thinning method can be used. The wafer thinned in that way having the edge reinforcement can now be deposited on an electrostatically activatable carrier wafer such that the thicker edge rests approximately in a form-locking manner on the edge depression of the carrier or comprises a small gap to the floor of the edge depression. Then, the electrostatic fixing can be activated, either in the above described unipolar or bipolar configuration. After activating the electrostatic holding force, the charge station and cable can be cut off again. The wafer stack can now be freely movable and can pass through further process steps. According to embodiments, the deposited wafer can now be provided with a photo resist layer, and the same can be exposed and developed (structured) with a mask or writing device. Subsequently, the wafer stack can be introduced into a plasma chamber where a trench structure can be deeply etched into the wafer by means of an anisotropic etching method. The trench can be implemented up to the rear of the thin deposited wafer. In this way, the thin wafer can be singulated into individual devices (e.g. Si chips). According to embodiments, the singulated Si chips can still be firmly held on the carrier substrate by the electrostatic fixing. After finishing the trenches (i.e. etching through), the etching process can be stopped and the carrier can be removed from the plasma chamber. In this way, it is possible to singulate the wafer area of virtually any thinness by means of a gentle etching process and to still securely fix all of the chips.

The configuration "singulated chips on an electrostatic carrier" can still be used in an advantageous manner for subsequent process steps in the assembly.

Due to the inventive carrier, there is the option to singulate a wafer with an edge reinforcement into individual chips even at a residual thickness of only 10 to 50 µm in a lithography process and trench etching process.

Additionally, due to the combinability of its mounting technologies, the carrier also enables a passage through longer process modules in semiconductor technology without changing the carrier. Reactivating the electrostatic holding forces is possible anytime by recharging.

In embodiments, the carrier with the edge depression can be made of one piece (e.g. a silicon wafer) or can be assembled of a combination of two or more parts.

In embodiments, a mostly plan-parallel wafer (i.e. without an edge reinforcement) can also be processed with the described carrier technology, when a circumferential stabilization ring is adhered on one side of the already thin wafer. This ring can be produced of silicon, glass, metal, ceramic or polymer.

Embodiments may comprise several passages (vias) for gases and several contact pads for charging. In embodiments, the carrier can have a square shape. Furthermore, the carrier can be produced in any size. There is no limitation to fixing wafer-shaped substrates (round wafers). According to embodiments, a deposited thin wafer can be transferred from one electrostatic carrier to another electrostatic carrier. Furthermore, not only semiconductor substrates can be fixed, but also substrates of insulating materials (e.g. glass) when the same comprise a conductive coating.

Embodiments of the present invention are important for practical applications. For different fields of application, semiconductor substrates, such as silicon wafers, have to be thinned to a material thickness of significantly below 100 µm. To these belong, for example, devices for power electronics, highly efficient solar cells and devices for highfrequency electronics based on gallium arsenide substrates. A further requirement for wafer substrates that continuously become thinner arises in the technology field of 3D integration and here in particular for the production of so-called "interposer wafers". The same are or will be used in the future as mechanical and electrical connecting elements between a top circuit wafer ("top wafer") and an underlying circuit wafer ("bottom wafer"). A specific feature of the field of application stated herein is the necessity to perform semiconductor technological method steps at the already very thin semiconductor substrates, both at their front and their back. To these belong, for example, depositing resist layers, lithography, wet-chemical or dry-chemical (plasma etching) structuring methods, depositing metallization layers (PVD, "sputtering", CVD), sintering metal layers at high temperatures (up to 450°C), ion implantation, depositing insulating layers (PECVD, CVD) and others.

For these wafers that continuously become thinner, stabilization technologies are necessitated to avoid fracture of the wafer during processing. The present invention is advantageous since it describes a concept and execution geometry for such a stabilization and carrier technology.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

The above described embodiments are merely illustrative for the principles of the present invention. It is understood that modifications and variations of the arrangements and the details described herein will be apparent to others skilled in the art. It is the intent, therefore, to be limited only by the scope of the pending patent claims and not by the specific details presented by way of description and explanation of the embodiments herein.

According to a first aspect, a carrier substrate 100 for supporting a substrate structure 200 having a process substrate 210 and a frame structure 220 comprises a base portion 110 and a support portion 120 arranged thereon, wherein the support portion 120 and the base portion 110 form a recess region 130 for receiving the frame structure 220 of the substrate structure 200, wherein the support portion 120 comprises a support surface area 122 for supporting the process substrate 210 of the substrate structure 200.

According to a second aspect when referring back to the first aspect, the recess region 130 is arranged laterally adjacent to the support surface area 122.

According to a third aspect when referring back to at least one of the first to second aspects, the support portion 120 and the base portion 110 form a step like recess region 130.

According to a fourth aspect when referring back to at least one of the first to third aspects, the carrier substrate 100 comprises a fixing device 410 for electrostatically fixing the substrate structure 200 to the carrier substrate 100.

According to a fifth aspect when referring back to the fourth aspect, the fixing device 410 comprises an electrode structure arranged on the carrier substrate 100, wherein the electrode structure is configured to electrostatically fix the substrate structure 200 using a unipolar configuration or a bipolar configuration.

According to a sixth aspect when referring back to at least one of the first to fifth aspects, the carrier substrate 100 comprises a fixing device 410 for mechanically fixing the substrate structure 200 to the carrier substrate 100.

According to a seventh aspect when referring back to at least one of the first to sixth aspects, the carrier substrate 100 comprises a via 450 extending through the base portion 110 and the support portion 120, wherein the via 450 extends from a bottom surface area 422 of the base portion 110 to the support surface area 122 of the support portion 120, wherein the bottom surface area 422 of the base portion 110 is opposite to the support surface area 122 of the support portion 120.

According to an eighth aspect when referring back to at least one of the first to seventh aspects, the carrier substrate 100 comprises a circular recess region 130 for receiving a circular frame structure 220 of the substrate structure 200.

According to a ninth aspect when referring back to at least one of the first to eighth aspects, the support portion 120 is formed integrally with the base portion 110.

According to a tenth aspect when referring back to at least one of the first to ninth aspects, the substrate structure 200 and the carrier substrate 100 comprise the same coefficient of thermal expansion.

According to an eleventh aspect when referring back to the tenth aspect, the substrate structure 200 and the carrier substrate 100 comprise silicon.

According to a twelfth aspect when referring back to at least one of the first to eleventh aspects, the recess region 130 has a lateral extension L ranging from 0.1 mm to 20 mm or from 0.2 mm to 10 mm, wherein the lateral extension L is parallel to the support surface area 122, wherein the recess region 130 has a vertical extension H ranging from 50 µm to 1 mm or from 100 µm to 500 µm, wherein the vertical extension H is parallel to a side surface area 124 of the support portion 120, wherein the side surface area 124 of the support portion 120 is adjacent to the support surface area 122.

According to a thirteenth aspect, a method for fixing a substrate structure 200 having a process substrate 210 and a frame structure 220 to a carrier substrate 100 comprises providing a carrier substrate 100, the carrier substrate 100 comprising a base portion 110 and a support portion 120 arranged thereon, wherein the support portion 120 and the base portion 110 form a recess region 130 for receiving the frame structure 220 of the substrate structure 200, wherein the support portion 120 comprises a support surface area 122 for supporting the process substrate 210 of the substrate structure 200; arranging the substrate structure 200 onto the carrier substrate 100 such that the frame structure 220 of the substrate structure 200 is received by the recess region 130.

According to a fourteenth aspect when referring back to the thirteenth aspect, the method further comprises electrostatically or mechanically fixing the substrate structure 200 to the carrier substrate 100.

According to a fifteenth aspect when referring back to at least one of the thirteenth to fourteenth aspects, the method further comprises applying an adhesive 510 onto a top surface area 112 of the base portion 110, wherein the top surface area 112 of the base portion 110 is adjacent to a side surface area 124 of the support portion 120, wherein the side surface area 124 of the support portion 120 is adjacent to the support surface area 122.

## Claims

1. A carrier substrate (100) configured for supporting a substrate structure (200) comprising a process substrate (210) and a reinforced frame structure (220), the carrier substrate (100) comprising:
a base portion (110) and a support portion (120) arranged thereon, wherein the support portion (120) and the base portion (110) form a recess region (130) configured for receiving the reinforced frame structure (220) of the substrate structure (200);
wherein the support portion (120) comprises a support surface area (122) configured for supporting the process substrate (210) of the substrate structure (200), and
**characterized in that**:
the carrier substrate (100) is a wafer-shaped substrate, and
a dimension of said carrier substrate (100) corresponds to a standard dimension of a semiconductor standard wafer.

2. The carrier substrate (100) according to claim 1, wherein the lateral extension of the carrier substrate (100) is 100 mm, 150 mm, 200 mm or 300 mm and/or wherein the vertical extension of the carrier substrate (100) ranges from 400 µm to 800 µm.

3. The carrier substrate (100) according to one of the preceding claims, wherein the recess region (130) is arranged laterally adjacent to the support surface area (122).

4. The carrier substrate (100) according to one of the preceding claims, wherein the support portion (120) and the base portion (110) form a step like recess region (130).

5. The carrier substrate (100) according to one of the preceding claims, wherein the carrier substrate (100) comprises a fixing device (410) for electrostatically or mechanically fixing the substrate structure (200) to the carrier substrate (100).

6. The carrier substrate (100) according to claim 5, wherein the fixing device (410) comprises an electrode structure arranged on the carrier substrate (100), wherein the electrode structure is configured to electrostatically fix the substrate structure (200) using a unipolar configuration or a bipolar configuration.

7. The carrier substrate (100) according to claim 5, wherein the fixing device (510) is an adhesive for reversibly fixing the substrate structure (200) to the carrier substrate (100).

8. The carrier substrate (100) according to claim 7, wherein the adhesive (510) comprises at least one of a thermally detachable glue, a chemically detachable polymer and a polymer that disintegrates under the effect of plasma.

9. The carrier substrate (100) according to one of the preceding claims, wherein the carrier substrate (100) comprises a via (450) extending through the base portion (110) and the support portion (120), wherein the via (450) extends from a bottom surface area (422) of the base portion (110) to the support surface area (122) of the support portion (120), wherein the bottom surface area (422) of the base portion (110) is opposite to the support surface area (122) of the support portion (120).

10. The carrier substrate (100) according to one of the preceding claims, wherein the carrier substrate (100) comprises a circular recess region (130) for receiving a circular frame structure (220) of the substrate structure (200).

11. The carrier substrate (100) according to one of the preceding claims, wherein the substrate structure (200) and the carrier substrate (100) comprise silicon, and/or wherein the carrier substrate (200) comprises glass, sapphire such as monocrystalline aluminum dioxide Al₂O₃, or a composite.

12. The carrier substrate (100) according to one of the preceding claims, wherein the recess region (130) comprises a lateral extension ranging from 0.1 mm to 20 mm or from 0.2 mm to 10 mm, wherein the lateral extension is parallel to the support surface area (122), wherein the recess region (130) comprises a vertical extension ranging from 50 µm to 1 mm or from 100 µm to 500 µm, wherein the vertical extension is parallel to a side surface area (124) of the support portion (120), wherein the side surface area (124) of the support portion (120) is adjacent to the support surface area (122).

13. A method for fixing a substrate structure (200) comprising a process substrate (210) and a reinforced frame structure (220) to a carrier substrate (100), the method comprising:
providing a wafer-shaped carrier substrate (100) comprising a dimension that corresponds to a standard dimension of a semiconductor standard wafer, the carrier substrate (100) comprising a base portion (110) and a support portion (120) arranged thereon, wherein the support portion (120) and the base portion (110) form a recess region (130) configured for receiving the frame structure (220) of the substrate structure (200), wherein the support portion (120) comprises a support surface area (122) configured for supporting the process substrate (210) of the substrate structure (200); and
arranging the substrate structure (200) onto the carrier substrate (100) such that the frame structure (220) of the substrate structure (200) is received by the recess region (130).

14. The method according to claim 13, further comprising electrostatically or mechanically fixing the substrate structure (200) to the carrier substrate (100).

15. The method according to one of claims 13 or 14, further comprising applying an adhesive (510) onto a top surface area (112) of the base portion (110), wherein the top surface area (112) of the base portion (110) is adjacent to a side surface area (124) of the support portion (120), wherein the side surface area (124) of the support portion (120) is adjacent to the support surface area (122).

## Patentansprüche

1. Ein Trägersubstrat (100), das dazu ausgebildet ist, eine Substratstruktur (200) zu stützen, die ein Prozesssubstrat (210) und eine verstärkte Rahmenstruktur (220) aufweist, wobei das Trägersubstrat (100) folgende Merkmale aufweist:
einen Basisabschnitt (110) und einen darauf angeordneten Stützabschnitt (120), wobei der Stützabschnitt (120) und der Basisabschnitt (110) eine Ausnehmungsregion (130) bilden, die dazu ausgebildet ist, die verstärkte Rahmenstruktur (220) der Substratstruktur (200) aufzunehmen;
wobei der Stützabschnitt (120) einen Stützoberflächenbereich (122) aufweist, der dazu ausgebildet ist, das Prozesssubstrat (210) der Substratstruktur (200) zu stützen, und
**dadurch gekennzeichnet, dass**:
das Trägersubstrat (100) ein Wafer-förmiges Substrat ist, und
eine Abmessung des Trägersubstrates (100) einer standardmäßigen Abmessung eines standardmäßigen Halbleiter-Wafers entspricht.

2. Das Trägersubstrat (100) gemäß Anspruch 1, wobei die laterale Erstreckung des Trägersubstrates (100) 100 mm, 150 mm, 200 mm oder 300 mm beträgt und/oder wobei die vertikale Erstreckung des Trägersubstrates (100) von 400 µm bis 800 µm reicht.

3. Das Trägersubstrat (100) gemäß einem der vorhergehenden Ansprüche, wobei die Ausnehmungsregion (130) lateral benachbart zu dem Stützoberflächenbereich (122) angeordnet ist.

4. Das Trägersubstrat (100) gemäß einem der vorhergehenden Ansprüche, wobei der Stützabschnitt (120) und der Basisabschnitt (110) eine Stufen-ähnliche Ausnehmungsregion (130) bilden.

5. Das Trägersubstrat (100) gemäß einem der vorhergehenden Ansprüche, wobei das Trägersubstrat (100) eine Befestigungsvorrichtung (410) aufweist, um die Substratstruktur (200) elektrostatisch oder mechanisch an dem Trägersubstrat (100) zu befestigen.

6. Das Trägersubstrat (100) gemäß Anspruch 5, wobei die Befestigungsvorrichtung (410) eine Elektrodenstruktur aufweist, die auf dem Trägersubstrat (100) angeordnet ist, wobei die Elektrodenstruktur dazu ausgebildet ist, die Substratstruktur (200) unter Verwendung einer unipolaren Konfiguration oder einer bipolaren Konfiguration elektrostatisch zu befestigen.

7. Das Trägersubstrat (100) gemäß Anspruch 5, wobei die Befestigungsvorrichtung (510) ein Haftmittel zum reversiblen Befestigen der Substratstruktur (200) an dem Trägersubstrat (100) ist.

8. Das Trägersubstrat (100) gemäß Anspruch 7, wobei das Haftmittel (510) einen thermisch lösbaren Kleber, ein chemisch lösbares Polymer und/oder ein sich unter dem Effekt eines Plasmas auflösendes Polymer aufweist.

9. Das Trägersubstrat (100) gemäß einem der vorhergehenden Ansprüche, wobei das Trägersubstrat (100) eine Durchkontaktierung (450) aufweist, die sich durch den Basisabschnitt (110) und den Stützabschnitt (120) erstreckt, wobei sich die Durchkontaktierung (450) von einem Bodenoberflächenbereich (422) des Basisabschnittes (110) zum dem Stützoberflächenbereich (122) des Stützabschnittes (120) erstreckt, wobei der Bodenoberflächenbereich (422) des Basisabschnittes (110) dem Stützoberflächenbereich (122) des Stützabschnittes (120) gegenüberliegt.

10. Das Trägersubstrat (100) gemäß einem der vorhergehenden Ansprüche, wobei das Trägersubstrat (100) eine kreisförmige Ausnehmungsregion (130) aufweist, um eine kreisförmige Rahmenstruktur (220) der Substratstruktur (200) aufzunehmen.

11. Das Trägersubstrat (100) gemäß einem der vorhergehenden Ansprüche, wobei die Substratstruktur (200) und das Trägersubstrat (100) Silizium aufweisen, und/oder wobei das Trägersubstrat (200) Glas, einen Saphir wie etwa monokristallines Aluminiumdioxid Al₂O₃ oder einen Verbundwerkstoff aufweist.

12. Das Trägersubstrat (100) gemäß einem der vorhergehenden Ansprüche, wobei die Ausnehmungsregion (130) eine laterale Erstreckung aufweist, die von 0,1 mm bis 20 mm oder von 0,2 mm bis 10 mm reicht, wobei die laterale Erstreckung parallel zu dem Stützoberflächenbereich (122) ist, wobei die Ausnehmungsregion (130) eine vertikale Erstreckung aufweist, die von 50 µm bis 1 mm oder von 100 µm bis 500 µm reicht, wobei die vertikale Erstreckung parallel zu einem Seitenoberflächenbereich (124) des Stützabschnittes (120) ist, wobei der Seitenoberflächenbereich (124) des Stützabschnittes (120) zu dem Stützoberflächenbereich (122) benachbart ist.

13. Ein Verfahren zum Befestigen einer Substratstruktur (200), die ein Prozesssubstrat (210) und eine verstärkte Rahmenstruktur (220) aufweist, an einem Trägersubstrat (100), wobei das Verfahren folgende Schritte aufweist:
Bereitstellen eines Wafer-förmigen Trägersubstrates (100), das eine Abmessung aufweist, die einer Standardabmessung eines standardmäßigen Halbleiter-Wafers entspricht, wobei das Trägersubstrat (100) einen Basisabschnitt (110) und einen darauf angeordneten Stützabschnitt (120) aufweist, wobei der Stützabschnitt (120) und der Basisabschnitt (110) eine Ausnehmungsregion (130) bilden, die dazu ausgebildet ist, die Rahmenstruktur (220) der Substratstruktur (200) aufzunehmen, wobei der Stützabschnitt (120) einen Stützoberflächenbereich (122) aufweist, der dazu ausgebildet ist, das Prozesssubstrat (210) der Substratstruktur (200) zu stützen, und
Anordnen der Substratstruktur (200) auf dem Trägersubstrat (100) derart, dass die Rahmenstruktur (220) der Substratstruktur (200) von der Ausnehmungsregion (130) aufgenommen wird.

14. Das Verfahren gemäß Anspruch 13, das ferner elektrostatisches oder mechanisches Befestigen der Substratstruktur (200) an dem Trägersubstrat (100) aufweist.

15. Das Verfahren gemäß einem der Ansprüche 13 oder 14, das ferner Anwenden eines Haftmittels (510) auf einem Oberseitenoberflächenbereich (112) des Basisabschnittes (110) aufweist, wobei der Oberseitenoberflächenbereich (112) des Basisabschnittes (110) zu einem Seitenoberflächenbereich (124) des Stützabschnittes (120) benachbart ist, wobei der Seitenoberflächenbereich (124) des Stützabschnittes (120) zu dem Stützoberflächenbereich (122) benachbart ist.

## Revendications

1. Substrat porteur (100) configuré pour supporter une structure de substrat (200) comprenant un substrat de processus (210) et une structure de cadre renforcée (220), le substrat porteur (100) comprenant:
une partie de base (110) et une partie de support (120) disposée sur cette dernière, où la partie de support (120) et la partie de base (110) forment une région d'évidement (130) configurée pour recevoir la structure de cadre renforcée (220) de la structure de substrat (200);
dans lequel la partie de support (120) comprend une zone de surface de support (122) configurée pour supporter le substrat de processus (210) de la structure de substrat (200), et
**caractérisé par le fait que**:
le substrat porteur (100) est un substrat en forme de plaquette, et
une dimension dudit substrat porteur (100) correspond à une dimension standard d'une plaquette standard de semi-conducteur.

2. Substrat porteur (100) selon la revendication 1, dans lequel l'extension latérale du substrat porteur (100) est de 100 mm, 150 mm, 200 mm ou 300 mm et/ou dans lequel l'extension verticale du substrat porteur (100) varie de 400 µm à 800 µm.

3. Substrat porteur (100) selon l'une des revendications précédentes, dans lequel la région d'évidement (130) est disposée latéralement adjacente à la zone de surface de support (122).

4. Substrat porteur (100) selon l'une des revendications précédentes, dans lequel la partie de support (120) et la partie de base (110) forment une région d'évidement en forme de gradin (130).

5. Substrat porteur (100) selon l'une des revendications précédentes, dans lequel le substrat porteur (100) comprend un dispositif de fixation (410) destiné à fixer de manière électrostatique ou mécanique la structure de substrat (200) au substrat porteur (100).

6. Substrat porteur (100) selon la revendication 5, dans lequel le dispositif de fixation (410) comprend une structure d'électrode disposée sur le substrat porteur (100), dans lequel la structure d'électrode est configurée pour fixer la structure de substrat (200) de manière électrostatique à l'aide d'une configuration unipolaire ou d'une configuration bipolaire.

7. Substrat porteur (100) selon la revendication 5, dans lequel le dispositif de fixation (510) est un adhésif destiné à fixer de manière réversible la structure de substrat (200) au substrat porteur (100).

8. Substrat porteur (100) selon la revendication 7, dans lequel l'adhésif (510) comprend au moins l'un parmi une colle thermiquement amovible, un polymère chimiquement amovible et un polymère qui se désintègre sous l'effet de plasma.

9. Substrat porteur (100) selon l'une des revendications précédentes, dans lequel le substrat porteur (100) comprend une traversée (450) s'étendant à travers la partie de base (110) et la partie de support (120), dans lequel la traversée (450) s'étend d'une zone de surface inférieure (422) de la partie de base (110) à la zone de surface de support (122) de la partie de support (120), dans lequel la zone de surface inférieure (422) de la partie de base (110) est opposée à la zone de surface de support (122) de la partie de support (120).

10. Substrat porteur (100) selon l'une des revendications précédentes, dans lequel le substrat porteur (100) comprend une région d'évidement circulaire (130) destinée à recevoir une structure de cadre circulaire (220) de la structure de substrat (200).

11. Substrat porteur (100) selon l'une des revendications précédentes, dans lequel la structure de substrat (200) et le substrat porteur (100) comprennent du silicium, et/ou dans lequel le substrat porteur (200) comprend du verre, du saphir tel que du dioxyde d'aluminium monocristallin Al₂O₃, ou un composite.

12. Substrat porteur (100) selon l'une des revendications précédentes, dans lequel la région d'évidement (130) comprend une extension latérale allant de 0,1 mm à 20 mm ou de 0,2 mm à 10 mm, dans lequel l'extension latérale est parallèle à la zone de surface de support (122), dans lequel la région d'évidement (130) comprend une extension verticale allant de 50 µm à 1 mm ou de 100 µm à 500 µm, dans lequel l'extension verticale est parallèle à une zone de surface latérale (124) de la partie de support (120), dans lequel la zone de surface latérale (124) de la partie de support (120) est adjacente à la zone de surface de support (122).

13. Procédé pour fixer une structure de substrat (200) comprenant un substrat de processus (210) et une structure de cadre renforcée (220) à un substrat porteur (100), le procédé comprenant le fait de:
prévoir un substrat porteur en forme de plaquette (100) comprenant une dimension qui correspond à une dimension standard d'une plaquette standard de semi-conducteur, le substrat porteur (100) comprenant une partie de base (110) et une partie de support (120) disposée sur cette dernière, où la partie de support (120) et la partie de base (110) forment une région d'évidement (130) configurée pour recevoir la structure de cadre (220) de la structure de substrat (200), où la partie de support (120) comprend une zone de surface de support (122) configurée pour supporter le substrat de processus (210) de la structure de substrat (200); et
disposer la structure de substrat (200) sur le substrat porteur (100) de sorte que la structure de cadre (220) de la structure de substrat (200) soit reçue par la région d'évidement (130).

14. Procédé selon la revendication 13, comprenant par ailleurs le fait de fixer de manière électrostatique ou mécanique la structure de substrat (200) au substrat porteur (100).

15. Procédé selon l'une des revendications 13 ou 14, comprenant par ailleurs le fait d'appliquer un adhésif (510) sur une zone de surface supérieure (112) de la partie de base (110), dans lequel la zone de surface supérieure (112) de la partie de base (110) est adjacente à une zone de surface latérale (124) de la partie de support (120), dans lequel la zone de surface - latérale (124) de la partie de support (120) est adjacente à la zone de surface de support (122).
